# EUROPÄISCHE PATENTSCHRIFT

(11) **EP 0 950 271 B1**
(45) Veröffentlichungstag und Bekanntmachung des Hinweises auf die Patenterteilung: **03.04.2002**
(21) Anmeldenummer: 97954823.7
(22) Anmeldetag: 18.12.1997
(51) Int. Cl.: H01R 12/04

(54) **BAUELEMENT FÜR EINE MESSWERKKONTAKTIERUNG UND VERFAHREN ZU DESSEN HERSTELLUNG**
COMPONENT FOR CONTACTING A MEASURING UNIT AND METHOD FOR ITS PRODUCTION
PIECE POUR LA MISE EN CONTACT D'UNE UNITE DE MESURE ET PROCEDE DE PRODUCTION DE LADITE PIECE

(30) Priorität: 24.12.1996 DE 19654382
(43) Veröffentlichungstag der Anmeldung: 20.10.1999
(73) Patentinhaber: Siemens Aktiengesellschaft, 80333 München (DE)
(72) Erfinder: MACIA, Antonio, Esteve, Ave. Nova Cantareira, 4504, CEP-Tremembé, SP (BR)
(74) Vertreter: Klein, Thomas, Dipl.-Ing. (FH)
(86) Internationale Anmeldenummer: EP9707130
(87) Internationale Veröffentlichungsnummer: WO9828819

(56) Entgegenhaltungen:
- DE-A- 4 039 625
- DE-A- 4 240 454
- US-A- 2 757 319
- US-A- 4 894 018
- US-A- 5 096 440

## Beschreibung

Die Erfindung bezieht sich auf ein Bauelement für eine Meßwerkkontaktierung, bei der ein Meßwerk mit mindestens zwei Kontaktelementen mit einer mindestens zwei Kontaktflächen auf einer Seite aufweisenden Leiterplatte durch eine Lötverbindung elektrisch kontaktierbar ist. Die Erfindung bezieht sich auch auf ein Verfahren zur Herstellung dieses Bauelementes.

Wenn Meßwerke, beispielsweise Drehmagnet-Quotientenmeßwerke, die vorzugsweise vier Kontaktelemente aufweisen mit einer kupferkaschierten Leiterplatte kontaktiert werden sollen, die nur an einer Seite die entsprechenden Kontaktflächen trägt, so besteht nur die Möglichkeit des Einsatzes von Einzelkontaktbuchsen zur Kontaktherstellung, wenn man einzelne, von Hand durchzuführende Lötarbeiten vermeiden will, die wegen des Vorhandenseins des Meßwerkes an der gleichen Seite der Leiterplatte, an der sich die Kontaktflächen befinden, sehr beschwerlich sind. Solche Kontaktbuchsen sind beispielsweise aus der DE 40 39 625 A1 bekannt. Dort finden Kontaktbuchsen Verwendung, die zum Einschrauben von gleichzeitig eine Kontaktierung herbeiführenden Befestigungsschrauben ausgebildet sind. Aber auch diese Kontaktierung und Befestigung in einem Arbeitsgang erfordert spezielle Kontaktbuchsen, zu deren Herstellung Spezialwerkzeuge erforderlich sind, sowie einen gewissen Montageaufwand, da in der Regel die Meßwerke mit vier Schrauben befestigt werden.

Aufgabe der Erfindung ist es, ein Bauelement herzustellen, mit dessen Hilfe einerseits die Lötverbindung zwischen diesem Bauelement und den Kontaktflächen der Leiterplatte und andererseits die Lötverbindung zwischen dem Bauelement und den Kontaktelementen des Meßwerkes jeweils maschinell und damit kostengünstig und schnell ausgeführt werden können.

Aufgabe der Erfindung ist es auch, ein Verfahren zur Herstellung eines solchen Bauelementes bereitzustellen.

Diese Aufgabe wird erfindungsgemäß dadurch gelöst, daß ein Träger eine Anzahl von Kontaktbrücken, die der Anzahl der Kontaktelemente des Meßwerkes entspricht, aufweist, daß jede Kontaktbrücke zwei Lötfahnen aufweist, die im wesentlichen rechtwinklig zueinander abgebogen sind, von denen die eine Lötfahne zur Herstellung einer Lötverbindung mit der Kontaktfläche der Leiterplatte durch diese hindurchsteckbar ist und die andere Lötfahne eine Öffnung zur Aufnahme des Kontaktelementes des Meßwerkes aufweist und daß der Träger an der den Kontaktflächen abgewandten Seite der Leiterplatte an dieser anliegend die Kontaktbrücken in einer der Kontaktelementenanordnung des Meßwerkes entsprechenden festen räumlichen Zuordnung hält.

Mit Hilfe eines solchen Bauelementes ist es möglich, zunächst das Bauelement an der den Kontaktflächen abgewandten Seite der Leiterplatte anzusetzen, wobei die Kontaktfahnen durch die Leiterplatte hindurchgesteckt werden. In diesem Zustand ist es möglich, die so bestückte Leiterplatte einem maschinellen Lötvorgang zu unterziehen, bei dem die hervorstehenden Enden der Lötfahnen mit den Kontaktflächen der Leiterplatte verlötet werden. Hierauf kann das Meßwerk auf die Leiterplatte von der Seite aufgesetzt werden, die die Kontaktflächen trägt. Dabei dringen die Kontaktelemente durch entsprechend vorbereitete Öffnungen in der Leiterplatte hindurch und können in die jeweiligen Öffnungen der Lötfahnen der Kontaktbrücken eingeführt werden. In diesem Zustand kann dann auf der dem Meßwerk abgewandten Seite der Leiterplatte wiederum mit einem maschinellen Lötvorgang eine Verbindung zwischen den Kontaktelementen des Meßwerkes und den Lötfahnen der Kontaktbrücken hergestellt werden. Eine solche Meßwerkkontaktierung ist deshalb so einfach, weil sie trotz des Vorhandenseins von Kontaktflächen nur auf derjenigen Seite der Leiterplatte, auf der das Meßwerk aufgesetzt werden soll, eine maschinelle Verlötung aller Kontaktelemente in jeweils einem Arbeitsgang ermöglicht, ohne daß besondere Montage- oder Ausrichtarbeiten bezüglich der Lötfahnen erforderlich wären, weil diese durch den Träger untereinander in einer festen räumlichen Zuordnung gehalten werden, die der räumlichen Anordnung der Kontaktelemente am Meßwerk entspricht. Wenn hier von einem Arbeitsgang bei der Lötverbindung gesprochen wird, so bezieht sich dies auf die Kontaktherstellung zwischen den Kontaktelementen des Meßwerkes einerseits und den Kontaktbrücken andererseits. Da aber beide Arbeitsgänge maschinell durchgeführt werden können und nur einen geringen Zeitaufwand erfordern, ist auch die Durchführung beider Arbeitsabläufe wesentlich rationeller als die Kontaktierung mittels Einzelkontaktbuchsen.

Um eine sichere Positionierung des Trägers mit den Kontaktbrücken an der Leiterplatte zu gewährleisten, kann der Träger in Weiterbildung der Erfindung Positionierungsstifte zu dessen räumlichen Ausrichtung an der Leiterplatte aufweisen.

Ein Verfahren zur Herstellung eines solchen Bauelementes ist erfindungsgemäß dadurch gekennzeichnet, daß aus einem elektrisch leitenden Material die Kontaktbrücken ausgestanzt werden, daß hierbei die Lötfahnen für die Kontaktelemente des Meßwerkes verbindende Verbindungsstege mitausgestanzt werden, daß die für die Kontaktierung mit den Kontaktflächen der Leiterplatte bestimmten Lötfahnen rechtwinklig zu den Lötfahnen der Kontaktelemente abgebogen werden, daß dieses Stanzteil mit einem die Kontaktbrücken in ihrem abgebogenen Bereich untereinander verbindenden, elektrisch isolierenden Kunststoff zur Bildung eines die Kontaktbrücken haltenden Trägers umspritzt werden und daß anschließend die Verbindungsstege herausgetrennt werden. Nach dem Heraustrennen der Verbindungsstege ist das Bauelement fertig und umfaßt räumlich in einem vorbestimmten Verhältnis zueinander stehende Kontaktbrücken, die durch den Kunststoff untereinander isoliert sind.

In Weiterbildung des Verfahrens können die Postitionierungsstifte bei der Herstellung des Trägers miteingespritzt werden.

Die Erfindung wird nachfolgend anhand eines in der Zeichnung dargestellten Ausführungsbeispieles näher erläutert. In der Zeichnung zeigen:
- **Figur 1:**: ein schematisch angedeutetes Meßwerk auf einer Leiterplatte im kontaktierten Zustand, wobei die Leiterplatte und das zur Kontaktierung dienende Bauelement im Schnitt dargestellt sind;
- **Figur 2:**: eine perspektivische Rückansicht eines zur Kontaktierung dienenden Bauelementes vor seiner endgültigen Herstellung;
- **Figur 3:**: eine perspektivische Vorderansicht des Bauelementes nach Figur 2; und
- **Figur 4:**: eine perspektivische Vorderansicht eines für die Kontaktierung fertigen Bauelementes.

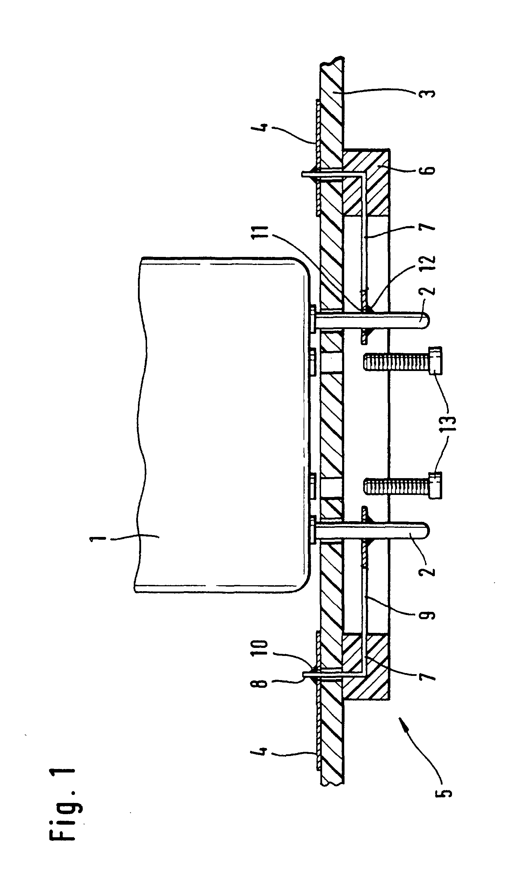

Figur 1 zeigt ein Meßwerk 1 mit zwei Kontaktelementen 2, die durch eine Leiterplatte 3 hindurchgesteckt sind, wobei das Meßwerk 1 auf der Leiterplatte 3 aufsitzt. Auf dieser Seite ist die Leiterplatte 3 mit Leiterbahnen bzw. Kontaktflächen 4 versehen. An der Unterseite der Leiterplatte 3, die frei von Kontaktflächen ist, ist ein insgesamt mit 5 bezeichnetes Bauelement angesetzt, das einen aus Kunststoff bestehenden Träger 6 und Kontaktbrücken 7 umfaßt, die zwei rechtwinklig zueinander abgebogene Lötfahnen 8 und 9 aufweisen. Die Lötfahnen 8 und 9 stehen über den Träger 6 hervor, so daß die Lötfahne 8 durch die Leiterplatte 4 hindurchgesteckt und mittels einer Lötverbindung 10 mit den Kontaktflächen 4 verlötet werden können. die anderen Lötfahnen 9 verlaufen parallel zur Leiterplatte 3 und sind mit Öffnungen 11 versehen, durch die die Kontaktelemente 2 hindurchgeführt und ebenso wie die Lötverbindungen 10 maschinell verlötet werden können, so daß Lötverbindung 12 entstehen. Mittels Schrauben 13 kann das Meßwerk 1 an der Leiterplatte festgeschraubt werden.

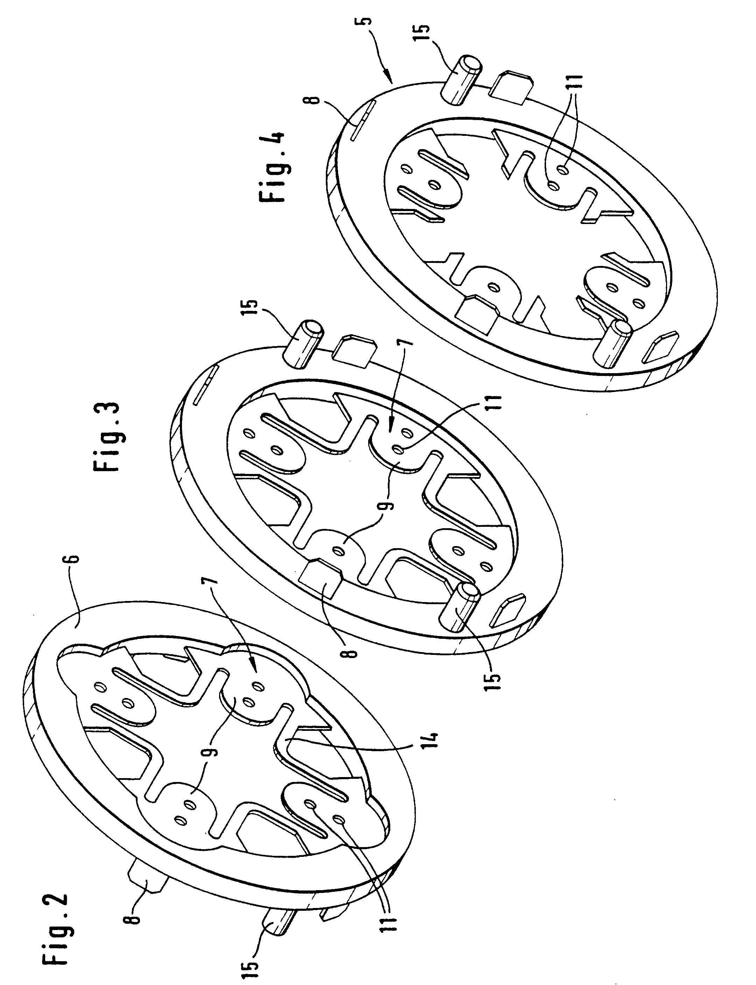

Wie aus den Figuren 2 bis 4 ersichtlich, sind für ein Drehmagnet-Quotientenmeßwerk vier Kontaktbrücken 7 in einem ringförmigen Träger 6 gehalten, wobei der Träger 6 durch Umspritzen der Kontaktbrücken 7 hergestellt ist. Vor diesem Spritzvorgang werden die Kontaktbrücken 7 aus einem flachen elektrisch leitenden Material ausgestanzt, wobei Verbindungsstege 14 zwischen den einzelnen Kontaktbrücken belassen werden, wobei die Verbindungsstege in der Ebene der Lötfahnen 9 liegen. Nach diesem Stanzvorgang werden die Lötfahnen 8 rechtwinklig abgebogen, wonach der Träger 6 durch Umspritzen dieses Stanzteiles gebildet wird. Hierbei befindet sich der Träger im wesentlichen im abgeknickten Bereich der Kontaktbrücken, so daß die Lötfahnen 8 und 9 über den Träger 6 hervorstehen. Dieses Stadium des Herstellungsvorganges ist in den Figuren 2 und 3 festgehalten. Mit 15 sind Positionierungsstifte bezeichnet, um den Träger 6 an der Leiterplatte zu sichern, damit beim Aufstecken des Meßwerkes 1 die Kontaktelemente 2 exakt in die Öffnungen 11 eingreifen können.

Figur 4 zeigt den fertigen Zustand eines Bauelementes, bei dem die Verbindungsstege 14 entfernt sind, so daß die Kontaktbrücken 7 zwar in einer festen räumlichen Zuordnung zueinander stehen, aber elektrisch untereinander nicht mehr verbunden sind.

In der Darstellung gemäß den Figuren 2 bis 4 sind die Lötfahnen 9 mit jeweils zwei Öffnungen 11 versehen. Hierdurch ist das Bauelement 5 auch für andere Meßwerke mit anderen Abständen zwischen den Kontaktelementen verwendbar.

## Patentansprüche

1. Bauelement für eine Meßwerkkontaktierung, bei der ein Meßwerk mit mindestens zwei Kontaktelementen mit einer mindestenes zwei Kontaktflächen auf einer Seite aufweisenden Leiterplatte durch eine Lötverbindung elektrisch kontaktierbar ist, **dadurch gekennzeichnet, daß** ein Träger (6) eine Anzahl von Kontaktbrücken (7), die der Anzahl der Kontaktelemente (2) des Meßwerkes (1) entspricht, aufweist, daß jede Kontaktbrücke (7) zwei Lötfahnen (8, 9) aufweist, die im wesentlichen rechtwinklig zueinander abgebogen sind, von denen die eine Lötfahne (8) zur Herstellung einer Lötverbindung mit der Kontaktfläche (4) der Leiterplatte (3) durch diese hindurchsteckbar ist und die andere Lötfahne (9) eine Öffnung (11) zur Aufnahme des Kontaktelementes (2) des Meßwerkes (1) aufweist und daß der Träger (6) an der den Kontaktflächen (4) abgewandten Seite der Leiterplatte (3) an dieser anliegend, die Kontaktbrücken (7) in einer der Kontaktelementenanordnung des Meßwerkes (1) entsprechenden festen räumlichen Zuordnung hält.

2. Bauelement nach Anspruch 1, **dadurch gekennzeichnet, daß** der Träger (6) Positionierungsstifte (15) zu dessen räumlicher Ausrichtung an der Leiterplatte (3) aufweist.

3. Verfahren zur Herstellung des Bauelementes nach Anspruch 1, **dadurch gekennzeichnet, daß** aus einem elektrisch leitenden Material Kontaktbrücken ausgestanzt werden, daß hierbei die Lötfahnen für die Kontaktelemente des Meßwerkes verbindende Verbindungsstege mitausgestanzt werden, daß die für die Kontaktierung mit den Kontaktflächen der Leiterplatte bestimmten Lötfahnen rechtwinklig zu den Lötfahnen der Kontaktelemente abgebogen werden, daß dieses Stanzteil mit einem die Kontaktbrücken in ihrem abgebogenen Bereich untereinander verbindenden elektrisch isolierenden Kunststoff zur Bildung eines die Kontaktbrücken haltenden Trägers umspritzt werden und daß anschließend die Verbindungsstege herausgetrennt werden.

4. Verfahren nach Anspruch 3 zur Herstellung eines Bauelementes nach Anspruch 2, **dadurch gekennzeichnet, daß** die Positionierungsstifte bei der Herstellung des Trägers miteingespritzt werden.

## Claims

1. Component for making contact with a measuring element, in which, by means of a soldered connection, electric contact can be made between a measuring element having at least two contact elements and a printed circuit board having at least two contact surfaces on one side, **characterized in that** a support (6) has a number of contact bridges (7) which corresponds to the number of contact elements (2) of the measuring element (1), **in that** each contact bridge (7) has two soldering tags (8, 9) which are bent off substantially at right angles to one another, of which one soldering tag (8) can be plugged through the printed circuit board (3) in order to produce a soldered connection with the contact surface (4) thereof, and the other soldering tag (9) has an opening (11) for accepting the contact element (2) of the measuring element (1), and **in that** on the side of the printed circuit board (3) averted from the contact surfaces (4) the support (6) keeps the contact bridges (7) bearing against said printed circuit board in a fixed spatial assignment corresponding to the contact element arrangement of the measuring element (1).

2. Component according to Claim 1, **characterized in that** the support (6) has positioning pins (15) for its spatial alignment on the printed circuit board (3).

3. Method for producing the component according to Claim 1, **characterized in that** contact bridges are punched out from an electrically conducting material, **in that** the soldering tags for connecting webs connecting the contact elements of the measuring element are also punched out in the process, **in that** the soldering tags intended for making contact with the contact surfaces of the printed circuit board are bent off at right angles to the soldering tags of the contact elements, **in that** this punching is encapsulated with an electrically insulating plastic connecting the contact bridges to one another in their bent-off region in order to form a support holding the contact bridges, and **in that** the connecting webs are subsequently disconnected.

4. Method according to Claim 3 for producing a component according to Claim 2, **characterized in that** the positioning pins are also injected during the production of the support.

## Revendications

1. Pièce pour la mise en contact d'une unité de mesure, avec laquelle une unité de mesure comportant au moins deux éléments de contact peut être mise en contact électrique par liaison brasée avec un circuit imprimé présentant au moins deux surfaces de contact sur une face, **caractérisée en ce qu'**un support (6) présente une pluralité de cavaliers de contact (7) qui correspondent à la pluralité d'éléments de contact (2) de l'unité de mesure (1), que chaque cavalier de contact (7) présente deux lames à braser (8, 9) qui sont pliées pour l'essentiel perpendiculairement l'une par rapport à l'autre, dont l'une des lames à braser (8) peut être insérée à travers la surface de contact (4) du circuit imprimé (3) pour réaliser une liaison brasée avec celle-ci et l'autre lame à braser (9) présente une ouverture (11) pour recevoir l'élément de contact (2) de l'unité de mesure (1) et que le support (6) sur lequel repose le côté du circuit imprimé (3) qui est opposé aux surfaces de contact (4) maintient les cavaliers de contact (7) dans une relation spatiale fixe correspondant à l'arrangement des éléments de contact de l'unité de mesure (1).

2. Pièce selon la revendication 1, **caractérisée en ce que** le support (6) présente des broches de positionnement (15) pour son alignement spatial sur le circuit imprimé (3).

3. Procédé pour la production de la pièce selon la revendication 1, **caractérisé en ce que** des cavaliers de contact sont matricés dans un matériau conducteur d'électricité, que les lames de brasage pour les barrettes de liaison qui relient les éléments de contact de l'unité de mesure sont ici également matricées, que les lames de brasage destinées à la mise en contact avec les surfaces de contact du circuit imprimé sont pliées en angle droit par rapport aux lames de brasage des éléments de contact, que cette pièce matricée est surmoulée avec une matière plastique électriquement isolante reliant les cavaliers de contact entre eux dans leur zone pliée pour former un support maintenant les cavaliers de contact et que les barrettes de liaison sont ensuite séparées.

4. Procédé selon la revendication 3 pour produire une pièce selon la revendication 2, **caractérisé en ce que** les broches de positionnement du support sont injectées en même temps.
